# EUROPÄISCHE PATENTSCHRIFT

(11) **EP 2 814 694 B1**
(45) Veröffentlichungstag und Bekanntmachung des Hinweises auf die Patenterteilung: **13.07.2016**
(21) Anmeldenummer: 13708065.1
(22) Anmeldetag: 22.01.2013
(51) Int. Cl.: B60Q 1/00, B60L 3/00, B60L 11/18, H05B 33/08, B60Q 1/50, G01R 31/36, G08B 5/36

(54) **STATUSANZEIGE FÜR DEN ZUSTAND EINER BETRIEBSRELEVANTEN KOMPONENTE EINES KRAFTFAHRZEUGS**
STATUS DISPLAY FOR THE STATE OF AN OPERATIONALLY-RELEVANT COMPONENT OF A MOTOR VEHICLE
ÉLÉMENT D'INDICATION DE L'ÉTAT D'UN COMPOSANT IMPORTANT POUR LE FONCTIONNEMENT D'UN VÉHICULE À MOTEUR

(30) Priorität: 16.02.2012 AT 1972012; 24.02.2012 AT 500412012; 13.09.2012 AT 10042012
(43) Veröffentlichungstag der Anmeldung: 24.12.2014
(73) Patentinhaber: Zizala Lichtsysteme GmbH, 3250 Wieselburg (AT)
(72) Erfinder: REINPRECHT, Markus, A-3250 Wieselburg (AT)
(74) Vertreter: Patentanwaltskanzlei Matschnig & Forsthuber OG
(86) Internationale Anmeldenummer: PCT/AT2013/050018
(87) Internationale Veröffentlichungsnummer: WO 2013/120120

(56) Entgegenhaltungen:
- EP-A1- 1 610 157
- WO-A2-2010/130743
- DE-A1-102007 036 697
- DE-A1-102008 007 801
- DE-A1-102010 017 759

## Beschreibung

Die Erfindung bezieht sich auf eine Statusanzeige für den Zustand einer betriebsrelevanten Komponente eines Kraftfahrzeugs.

Für den Benutzer eines Kraftfahrzeuges ist es wesentlich, über den Zustand bestimmter Komponenten des Fahrzeuges rasche Information zu erhalten, wobei solche Komponenten im Zusammenhang mit der Erfindung als "betriebsrelevant" bezeichnet werden. Beispiele für solche Zustände von Komponenten sind der Ladezustand einer Akkumulatorenbatterie eines Elektro- oder Hybridfahrzeugs oder der Füllzustand eines Treibstofftanks, der Reifendruck, die Motortemperatur etc. Solche Zustände werden üblicherweise erst sichtbar, nachdem der Benutzer in oder auf dem Fahrzeug Platz genommen hat und meist erst nach Betätigen eines (Zünd)schalters.

Von außen sind an einem Kraftfahrzeug meist Beleuchtungen erkennbar, seien es Scheinwerfer, Blinkleuchten, Bremslichter etc., die oft schon beim Öffnen des Fahrzeuges mittels einer Fernbedienung aktiviert werden. Das Dokument WO 2010 130743 offenbart eine Statusanzeige für einen Kraftfahrzeug.

Eine Aufgabe der Erfindung liegt darin, die erwähnten Zustände betriebsrelevanter Komponenten eines Kraftfahrzeugs für einen Benutzer bereits von außen ersichtlich zu machen, beispielsweise bei Annäherung des Benutzers an ein Fahrzeug, gegebenenfalls nach Betätigung einer Fernbedienung.

Zur Lösung dieser Aufgabe sieht die Erfindung vor, dass bei einer Statusanzeige für den Zustand einer betriebsrelevanten Komponente eines Kraftfahrzeugs an einer von außen sichtbaren Position des Fahrzeugs eine von zumindest zwei Lichtquellen angespeiste längliche Leuchtstruktur angeordnet ist und den Lichtquellen eine Ansteuerschaltung zugeordnet ist, welche dazu eingerichtet ist, die Lichtquellen in Abhängigkeit eines für den Zustand der betriebsrelevanten Komponente repräsentativen Zustandssignals so anzusteuern, dass die Leuchtdichte und/oder Farbe längst der Leuchtstruktur skalenartig den Zustand der Komponente anzeigt.

Dank der Erfindung ist es auch unter Verwendung von an dem Kraftfahrzeug ohnedies vorhandener Beleuchtungsstrukturen möglich, den Benutzer sofort über bestimmte, vor allem kritische Zustände zu informieren. Wird beispielsweise dem Benutzer angezeigt, dass die Akkumulatorenbatterie seines Elektrofahrzeugs leer oder fast leer ist, so wird der Benutzer gar nicht in sein Fahrzeug einsteigen sondern für ein Laden der Batterie Sorge tragen.

Bei einer zweckmäßigen Variante kann vorgesehen sein, dass die Leuchtstruktur zwei oder mehr der Struktur zugeordnete Lichtquellen besitzt, da sich durch Wahl der Position und Ausbildung der Lichtquellen eine Vielzahl von praxisgerechten Ausbildungen ergibt.

Weiters kann die Leuchtstruktur mit Vorteil als Reflektormatrix ausgebildet sein, zumal eine solche Reflektormatrix ein oft schon vorhandener Bestandteil einer Leuchteinheit ist.

Eine besonders zweckmäßige Variante zeichnet sich dadurch aus, dass die Leuchtstruktur als Leuchtstab ausgebildet ist. Leuchtstäbe sind nämlich in ihrer Form und Länge äußerst variabel gestaltbar und somit vielseitig einsetzbar.

Bei einer weiteren Ausbildungsvariante kann vorgesehen sein, dass jede Lichtquelle zumindest eine Leuchtdiode aufweist und jeder Leuchtdiode eine Ansteuerschaltung zugeordnet ist, welche eine zur Leuchtdiode parallel geschaltete Serienschaltung einer Referenzspannungssenke der Spannung und eines gesteuerten Schalters aufweist und die dazu eingerichtet ist, die Steuerspannung an einer allen Ansteuerschaltungen gemeinsamen Steuerleitung, gemessen gegen einen Fußpunkt der LED-Serienschaltung, mit der Spannung an der Verbindung des Schalters mit der darauffolgenden LED der Kette bzw. dem Fußpunkt zu vergleichen und den Schalter zu schließen bzw. zu öffnen, falls die Steuerspannung unter einen vorgegebenen Wert fällt bzw. über einen vorgegebenen Wert steigt. Bei einer derartigen Ausbildung ist der Verdrahtungsaufwand für die Leuchtdiodenkette minimal.

Bei einer anderen Variante der Erfindung besitzt die Leuchtstruktur zumindest einen Leuchtstab mit zumindest zwei Lichteinspeisepositionen, welchen je eine Lichtquelle zugeordnet ist, wobei der Lichtleiter zur Führung des eingespeisten Lichts sowie zur Abstrahlung von Licht auf Grund von an dem Lichtleiter ausgebildeten Störstellen eingerichtet ist, und die Ansteuerschaltung dazu eingerichtet ist, die Lichtquellen an den beiden Lichteinspeisepositionen dem Zustand der Komponente entsprechend anzusteuern. Ein solcher Leuchtstab kann z.B. leicht in vorhandene Beleuchtungsmittel integriert werden, ohne die Ästhetik zu verschlechtern.

In vielen Fällen kann die Anzeige aussagekräftiger gestaltet werden, falls die Lichtquellen eine unterschiedliche Farbe abstrahlen.

Es ist des Weiteren in Hinblick auf Energiebedarf und Wärmeentwicklung oft empfehlenswert, wenn die Lichtquellen als Leuchtdioden ausgebildet sind.

Zu kompakten und kostengünstigen Ausbildungen gelangt man auch, wenn die Leuchtstruktur der Statusanzeige in/an einer Scheinwerfereinheit des Kraftfahrzeuges angeordnet ist.

Die Erfindung samt weiteren Vorteilen ist im Folgenden an Hand beispielsweiser Ausführungsformen näher erläutert, die in der Zeichnung veranschaulicht sind. In dieser zeigen
Fig. 1 schematisch die Ansteuerung der Leuchtstruktur einer erfindungsgemäßen Statusanzeige,
Fig. 2 eine Ausführungsform der Erfindung mit Anordnung einer Leuchtstruktur in einem Frontscheinwerfer, schematisch von vorne gesehen,
Fig. 3 eine Variante, ähnlich der Ausführung nach Fig. 2,
Fig. 4 in einem Blockschaltbild den prinzipiellen Aufbau einer Leuchtdiodenkette für eine Leuchtstruktur nach der Erfindung,
Fig. 5 das Schaltbild einer LED-Ansteuerung einer Leuchtdiode einer Leuchtdiodenkette,
Fig. 6 bis 8 verschiedene Betriebsstadien einer beispielsweisen Leuchtdiodenkette mit vier Leuchtdioden,
Fig. 9a bzw. Fig. 9b in Diagrammen den zeitlichen Verlauf einer fallenden bzw. steigenden Steuerspannung sowie der Anzahl der je leuchtenden Leuchtdioden einer Kette mit vier Leuchtdioden,
Fig. 10 schematisch einen an seinen beiden Enden angesteuerten Leuchtstab,
Fig. 11 die Ansicht eines Abschnittes eines bei der Erfindung verwendeten Lichtleiters,
und die Fig. 12a und 12b beispielsweise Intensitätszustände der beiden Lichtquellen an den Enden des Leuchtstabes der Fig. 10.

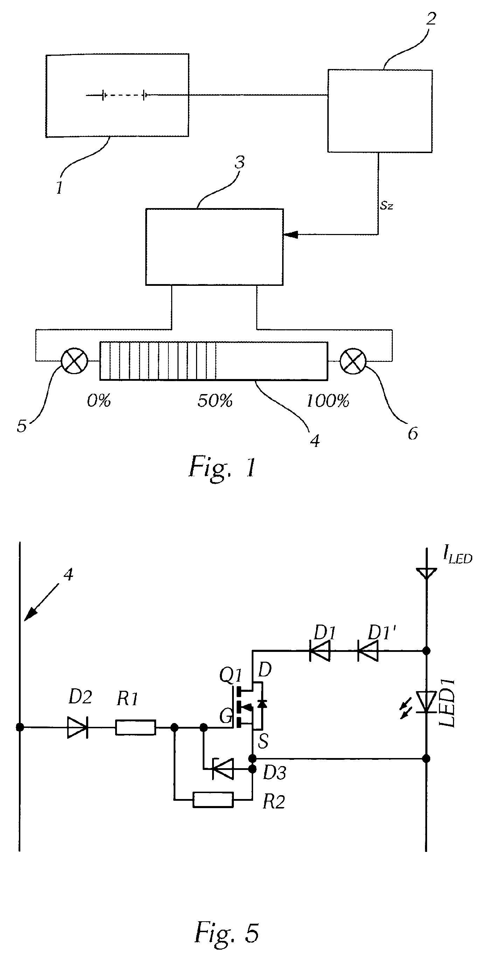

Gemäß Fig. 1 wird der Zustand einer für den Betrieb eines hier nicht näher gezeigten Kraftfahrzeugs relevanten Komponente 1 von einer Auswerteeinrichtung 2 erfasst, welche ein Zustandssignal sz abgibt. Die Komponente 1 ist im vorliegenden Beispiel die Akkumulatorenbatterie eines Elektro- oder Hybridfahrzeugs und die Auswerteeinrichtung erfasst den aktuellen Ladezustand der Batterie, wobei das Zustandssignal sz den Ladezustand anzeigt. Die Komponente 1 kann aber auch der Treibstofftank eines Fahrzeugs sein, wobei die Auswerteeinrichtung den Füllzustand des Tanks erfasst. Andere Zustandssignale könnten die Kühlmittel/Öltemperatur eines Motors des Fahrzeugs etc. sein.

Das Zustandssignal sz steuert über eine Ansteuerschaltung 3 eine längliche Leuchtstruktur 4 an, die zumindest zwei Lichtquellen 5, 6 aufweist. Die Ansteuerschaltung ist nun dazu ausgebildet, die Lichtquellen so anzusteuern, dass in Abhängigkeit von dem Zustand der betriebsrelevanten Komponente, z.B. in Abhängigkeit von dem Ladezustand der Akkumulatorenbatterie, die Leuchtdichte und/oder Farbe längs der Leuchtstruktur 4 nach Art einer Skala den Zustand der Komponente anzeigt. Beispielsweise seien in Fig. 1 am linken Ende der Leuchtstruktur 0 % (leere Batterie) und am rechten Ende 100 % (volle Batterie) angenommen, wobei in Fig. 1 ein etwa 50 %-Ladezustand angenommen ist, bei welchem die Struktur 4 von links beginnend bis zur Hälfte ausgeleuchtet ist. Das Ausleuchten der Leuchtstruktur 4 kann im einfachsten Fall mit weißem Licht oder monochromatisch erfolgen, doch ist es auch möglich, durch Verwendung farbiger Lichtquellen beispielsweise einen grünroten Übergang zu erzeugen, der je nach Zustand der Komponente "wendet". Dem Fachmann stehen viele Realisierungsmöglichkeiten zur Bildung einer solchen Lichtskala zur Verfügung, wobei weiter unten Ausführungsbeispiele erläutert werden.

Die Erfindung sieht weiters vor, dass die Leuchtstruktur an einer von außen sichtbaren Position des Kraftfahrzeugs angeordnet ist. Der Begriff "von außen sichtbar" ist dahingehend zu verstehen, dass die Statusanzeige nach der Erfindung beispielsweise nicht, wie üblich, in dem Armaturenbrett oder sonst in unmittelbarer Sichtweite des Fahrers vorhanden ist, sondern an der Außenseite des Fahrzeugs oder jedenfalls von außen sichtbar. Mögliche Beispiele für eine Realisierung sind Streifen an der Außenseite einer Karosserie oder eine Integration in vorhandene Fahrzeugleuchten, seien es Scheinwerfer, Bremslichtstrukturen oder dgl.

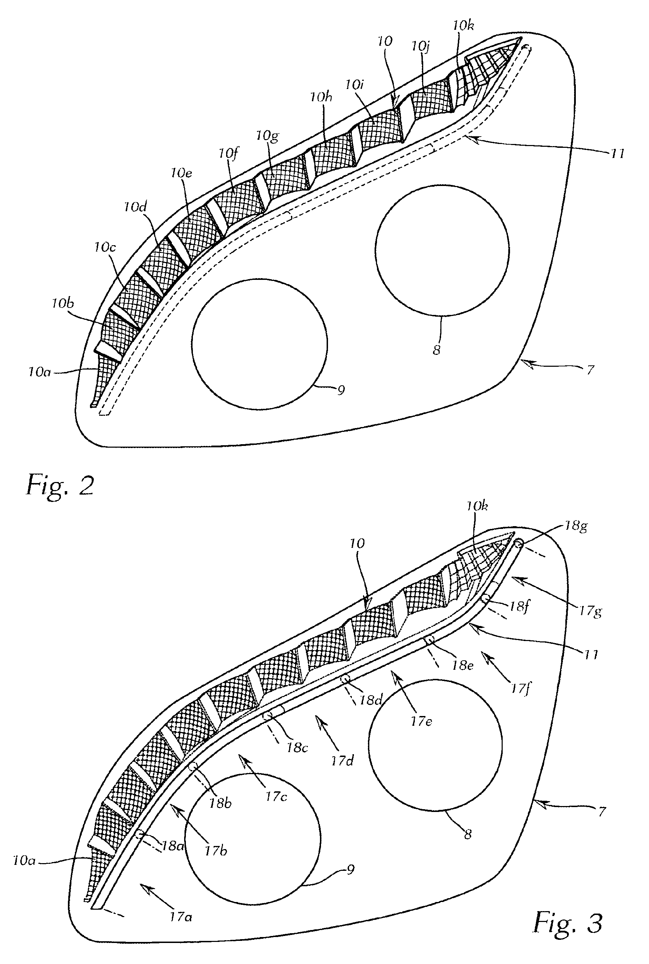

In den Fig. 2 und 3 sind zwei Ausführungsbeispiele bezüglich der Anordnung erfindungsgemäßer Statusanzeigen in Fronscheinwerfern gezeigt, wobei in beiden Fällen eine Scheinwerfereinheit 7 beispielsweise eine Abblendeinheit 8 und eine Fernlichteinheit 9 enthält. Weiters sind eine Reflektormatrix 10 sowie ein Leuchtstab 11 in dem Scheinwerfer, hier oberhalb der Einheiten 8 und 9 schräg verlaufend, angeordnet. Die Reflektormatrix 10 und der Leuchtstab 11 sind z.B. entsprechend Designvorgaben leicht gekrümmt bzw. geschwungen.

Die Reflektormatrix 10, die in dem gezeigten Beispiel elf Reflektorfelder 10a ... 10k aufweist, die je von einer nicht näher ersichtlichen LED oder auch je von mehreren LEDs ausgeleuchtet werden kann, wird beispielsweise als Blinkleuchte, Tagfahrlicht, Positionslicht verwendet. Der unterhalb der Reflektormatrix 10 optional angeordnete, strichliert eingezeichnete Leuchtstab 11 kann an zwei oder mehr Stellen von LEDs angespeist werden und beispielsweise als Positionslicht oder anderen Zwecken dienen.

Bei der Ausführung nach Fig. 2 wird die Reflektormatrix 10 mit ihren elf Reflektorfeldern auch als Leuchtstruktur für die erfindungsgemäße Statusanzeige herangezogen. Beispielsweise werden dem Ladezustand einer Akkumulatorenbatterie oder dem Füllzustand eines Kraftstofftanks entsprechend von links nach rechts im Sinne einer Skala mehr oder weniger Reflektorfelder 10a ... 10k durch die ihnen zugeordneten Lichtquellen beleuchtet. Ein Beispiel für eine von vielen möglichen Ansteuervarianten wird nachstehend für vier Lichtquellen gegeben.

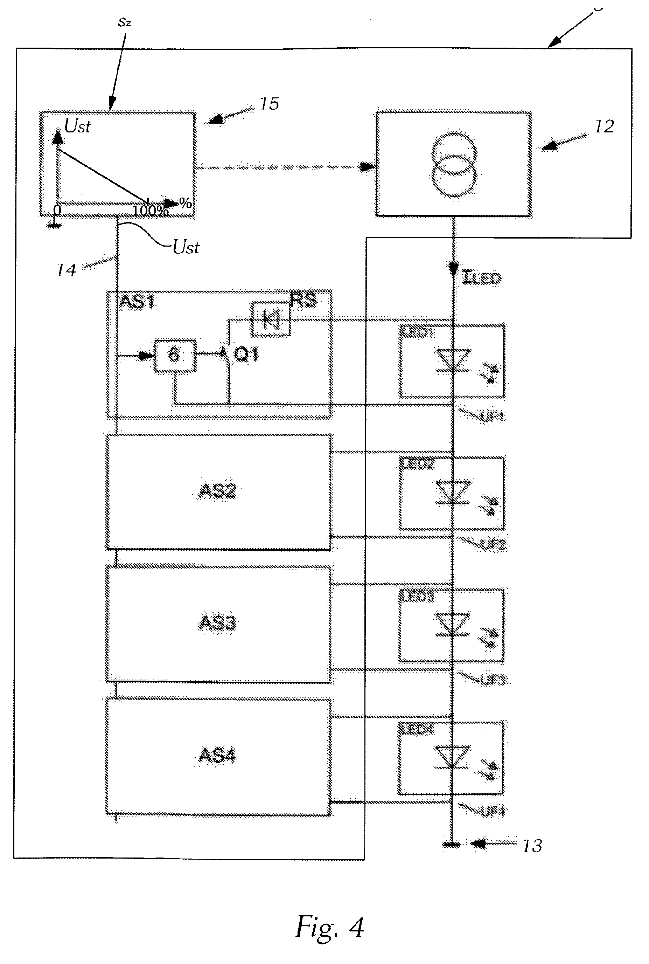

Fig. 4 zeigt den Aufbau einer Leuchtdiodenkette für eine Leuchtstruktur nach der Erfindung: eine Stromquelle 12 liefert einen Strom ILED und speist mittels der Ansteuerschaltung 3 bei diesem Beispiel vier in Serie geschaltete Leuchtdioden LED1 bis LED4 gegen einen Fuß- oder Massepunkt 13. Diese vier Leuchtdioden können beispielsweise einer Reflektormatrix ähnlich der Reflektormatrix 10 nach Fig. 2 zugeordnet sein, wobei eine solche Matrix lediglich vier Reflektorfelder hätte und nicht elf wie jene nach Fig. 2.

Jeder Leuchtdiode LED1....LED4 ist eine LED-Ansteuerung AS1 bis AS4 zugeordnet, welche eine zur zugehörigen Leuchtdiode parallel geschaltete Serienschaltung einer Referenzspannungssenke RS der Spannung Uref und eines gesteuerten Schalters Q aufweist.

Eine allen LED-Ansteuerungen AS1 bis AS4 gemeinsame Steuerleitung 14 liegt an dem Ausgang eines Rampengenerators 15, dem das Zustandssignal sz zugeführt ist und ist über eine hier symbolisch eingezeichnete Vergleichsschaltung 6 der LED-Ansteuerungen mit den Steuereingängen der gesteuerten Schalter verbunden. Dabei ist jede LED-Ansteuerung dazu eingerichtet, eine Steuerspannung Ust, die an der Steuerleitung 14, gemessen gegen einen Fußpunkt 13 liegt, mit der Spannung UF1 bis UF4 an der Verbindung des Schalters Q mit der darauffolgenden Leuchtdiode LD2 der Kette bzw. dem Fußpunkt 13 zu vergleichen und den Schalter Q zu öffnen, falls die Steuerspannung Ust unter einen vorgegebenen Wert fällt bzw. den Schalter Q zu schließen falls die Steuerspannung Ust über einen vorgegebenen Wert ansteigt. Insgesamt wird mit fallender Steuerspannung die Anzahl der leuchtenden LEDs größer. In dem symbolischen Diagramm in dem Block 15 des Rampengenerators ist daher als Beispiel auf der Ordinate die Steuerspannung Ust und auf der Abszisse ein steigender Ladezustand einer Akkumulatorenbatterie eingezeichnet.

Bei den Leuchtdioden LED1... LED4 der Leuchtdiodenkette muss es sich nicht notwendigerweise um eine einzelne Leuchtdiode handeln, es können an Stelle einer Leuchtdiode auch Serien- und/ oder Parallelschaltungen von Leuchtdioden vorgesehen sein. Eine strichliert eingezeichnete Leitung zwischen dem Rampengenerator 15 und der Stromquelle 12 soll andeuten, dass gegebenenfalls eine zusätzliche Steuerung des Stroms ILED erfolgen kann.

Da sämtliche LED-Ansteuerungen identisch ausgebildet sind, soll nachstehend unter Bezugnahme auf Fig. 5 ein praxiserprobtes Ausführungsbeispiel einer LED-Ansteuerung im Detail beschrieben werden, welche der ersten Leuchtdiode LED1 der Kette zugeordnet sein möge.

Parallel zur Leuchtdiode LED1 liegt die Serienschaltung zweier in Durchlassrichtung geschalteter Dioden, welche insgesamt mit D1 bezeichnet sind und eine Referenzspannungssenke bilden, mit der Schaltstrecke D-S eines MOSFETs Q, dessen Source S an der Katode der Leuchtdiode LED1 und dessen Drain D an der Katode der Diode(n) D1 liegt. Das Gate des Transistors Q liegt über die Serienschaltung eines Schutzwiderstandes R1 und einer Trenndiode D2 an der Steuerleitung 14. Source S und Gate G des MOSFETs Q sind einerseits von einer Zenerdiode D3 und andererseits von einem Widerstand R2 überbrückt.

Die Trenndiode D2 verhindert Rückwirkungen auf die jeweils übrigen Schaltungen der Leuchtdiodenkette und der Schutzwiderstand R1 verhindert in Kombination mit der Zenerdiode D3 schädlich hohe Spannungen an der Gate-Source-Strecke des MOSFET. Der Widerstand R2 stellt sicher, dass der MOSFET-Schalter trotz des Vorhandenseins der Diode D2 ausgeschaltet werden kann. Der Diode D1 kommt überdies die Aufgabe zu, die unvermeidbaren Gate-Source Spannungstoleranzen des MOSFETs Q1 auszugleichen und den Umstand zu berücksichtigen, dass ein FET keinen exakten Schaltpunkt besitzt.

Die nachstehend gegebenen Spannungswerte sollen lediglich zur besseren Erläuterung der Funktion der Erfindung dienen und hängen von den je verwendeten Bauteilen und der Schaltungsdimensionierung ab. Im gezeigten Ausführungsbeispiel sind die beiden, die Referenzspannungsdiode D1 bildenden Dioden beispielsweise Schottky-Dioden mit einer typischen Flussspannung von je 0,6 Volt, sodass die Referenzspannung Uref der Referenzspannungssenke D1 bei Nennstrom der Leuchtdioden 1,2 Volt beträgt. Die Zenerspannung der Zenerdiode D3 beträgt 8,2 Volt, die Durchlassspannung der Diode D2 0,6 Volt. Der MOSFET Q wird typisch ab einer Gate-Source-Spannung von 2 Volt leitend. Die Durchlassspannung der Leuchtdioden beträgt typisch 2 Volt.

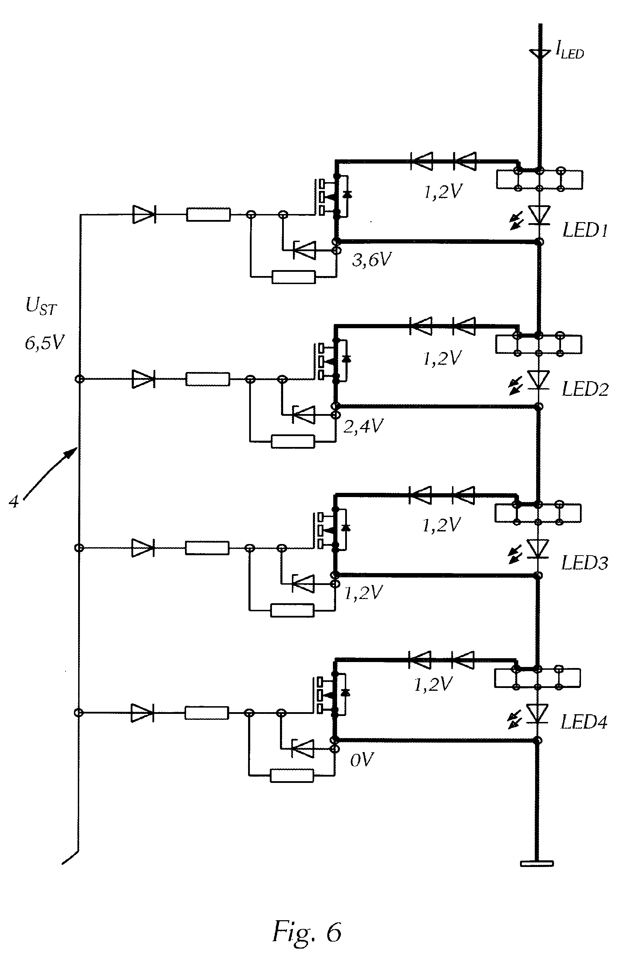

Unter weiterer Bezugnahme auf die Fig. 6 bis 8 sei nun die Funktion einer vierstufigen Leuchtdiodenkette erläutert, wobei es für den Fachmann klar ist, dass die Erfindung keineswegs auf eine bestimmte Anzahl von Leuchtdioden beschränkt ist und bei entsprechender Dimensionierung mehr oder weniger als vier Stufen vorgesehen sein können. Erläutert werden nachstehend nur zwei der vier möglichen zustände der Leuchtdiodenkette.

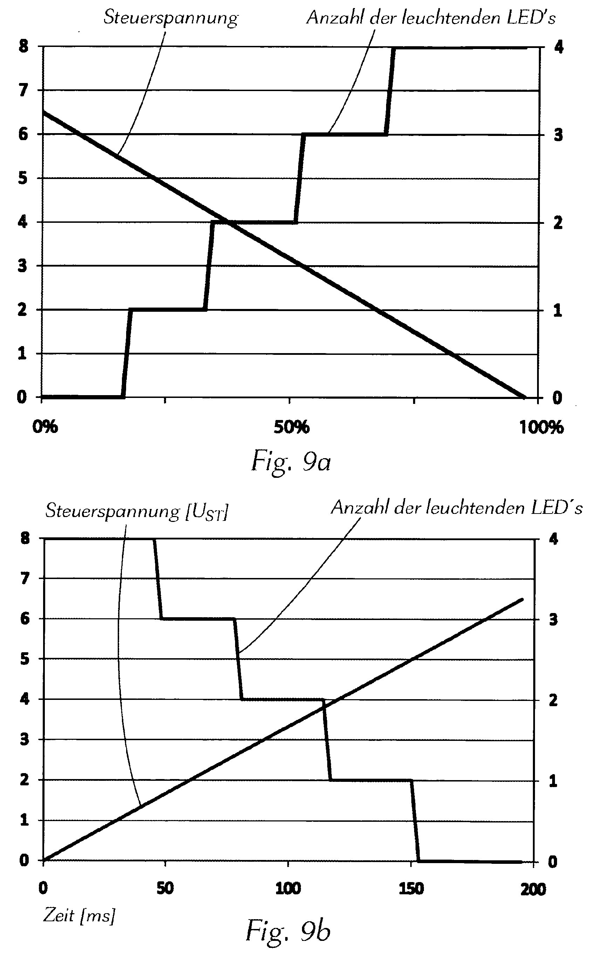

In einer ersten Phase nach Fig. 6 betrage die Steuerspannung Ust 6,5 Volt. Die Spannung an der Verbindung der Schalter Q mit der darauffolgenden LED der Kette bzw. dem Fußpunkt beträgt 3,6 Volt, 2,4 Volt 1,2 Volt bzw. 0 Volt. Die Gate-Source-Spannung jedes MOSSFETs ist größer als 2 Volt, nämlich 2,3 Volt, 3,5 Volt, 4,7 Volt und 5,9 Volt für die erste bis vierte Stufe, daher sind sämtliche MOSFETs Q durchgesteuert und ihre Drain-Source-Spannung liegt annähernd bei 0 Volt. An den Leuchtdioden LED1 bis LED4 liegt je eine Spannung von 1,2 Volt, im Wesentlichen entsprechend der Referenzspannung URef. Diese Spannung liegt deutlich unterhalb der Durchlassspannung der Leuchtdioden von 2 Volt, es leuchtet keine Leuchtdiode. In dem Diagramm der Fig. 9 entspricht dies dem Ausgangspunkt der fallenden Spannungsrampe.

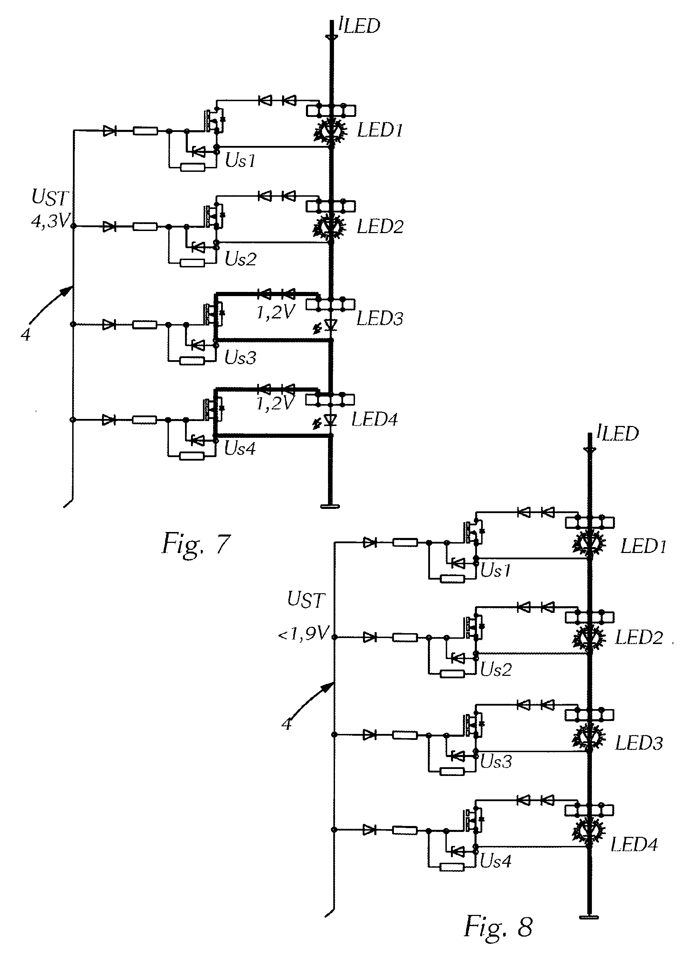

In Fig. 7 ist die Steuerspannung Ust auf 4,3 Volt abgesunken, die Gate-Source-Spannung des MOSFETs der ersten Stufe beträgt nur noch 0,1 Volt, jene des MOSFETs der zweiten Stufe nur noch 1,3 Volt, daher sperrt außer dem Schalter Q1 der ersten Stufe auch der Schalter der zweiten Stufe und die zweite Leuchtdiode LED1 leuchtet ebenso wie die erste Leuchtdiode LED 2.

In der Phase, die in Fig. 8 gezeigt ist, leuchten sämtliche Leuchtdioden LED1 bis LED4, da bei einer Steuerspannung Ust von unter 1,9 Volt die Gate-Source-Spannungen an den MOSFETs der einzelnen Stufen (in der Zeichnung von oben nach unten) nun 0 Volt, 0 Volt, 0 Volt und 1,3 Volt betragen.

Für die Sourcespannungen Us₁, Us₂, Us₃ und Us₄ sind in den Fig. 7 und 8 keine konkreten Werte angegeben, zumal die Spannung Us₁ in Fig. 7 und die Spannungen Us₁, Us₂ und Us₃ in Fig. 8 von den Flussspannungen der vorgehenden LEDs bestimmt sind, die typen- bzw. leistungsabhängig sind.

Insgesamt führt die beschrieben Funktionsweise bei einer beispielsweise linear fallenden, von dem Rampengenerator 5 erzeugten Steuerspannung USt dazu, dass ein laufender, die Leuchtdiodenkette "anfüllender" Lichteindruck entsteht. Dazu sei nochmals auf Fig. 9a verwiesen, welche diese Funktionsweise für einen Zeitabschnitt von 200 ms demonstriert. Wie bereits erwähnt, kann der Verlauf der Steuerspannung auch anderen beliebigen Funktionen an Stelle einer linearen Funktion folgen.

Es versteht sich, dass ein gegenteiliger Verlauf bei steigender Steuerspannung auftritt. Dies ist in Fig. 9b dargestellt, wobei auf der Abszisse wiederum der Füllzustand eine Akkumulators in Prozent aufgetragen ist.

Nicht im Detail dargestellt ist die bereits oben angedeutete Möglichkeit, in gewissem Ausmaß die Stromquelle 12 durch den Rampengenerator 15 zu steuern, sodass noch weitere Effekte erzielbar sind, z.B. eine beim "Auffüllen" der Kette ansteigende Helligkeit der Leuchtdioden.

Die gezeigte Ansteuerungsmöglichkeit hat den Vorteil, dass unabhängig von der Anzahl der verwendeten LEDs lediglich drei Leitungen für die Leuchtdiodenkette erforderlich sind. Die einfache und billige Ansteuerschaltung kann auf kleinsten Raum unmittelbar bei der Leuchtdiode aufgebaut sein. Natürlich können die Leuchtdioden auch auf andere bekannte Weise direkt, d.h. ohne die einzelnen LED-Ansteuerungen angesteuert werden, falls die Anzahl der benötigten Leitungen keine große Rolle spielt.

Es wird nun wieder auf Fig. 3 Bezug genommen, welche eine Ausführungsform darstellt, bei welcher in Verbindung mit der Erfindung nicht die Reflektormatrix 10 zum Einsatz gelangt, sondern der Leuchtstab 11. In dem dargestellten Beispiel besitzt dieser Leuchtstab, welcher außerdem als Blinklicht, Positionslicht und Tagfahrlicht verwendet werden kann, sieben Ausleuchtzonen 17a....17g, wobei jede Ausleuchtzone an einer Einkoppelstelle 18a....18g wie unten noch näher beschrieben von einer Lichtquelle, z.B. von je einer oder je mehreren LEDs ausgeleuchtet wird.

Die Ansteuerung der Lichtquellen erfolgt sinngemäß durch die Ansteuerschaltung 3, wobei dem Zustand der betriebsrelevanten Komponente entsprechend ein mehr oder weniger langer Bereich des Leuchtstabes 11 im Sinne einer Skala ausgeleuchtet wird. Wenngleich in Fig. 3 sieben Einkoppelstellen für sieben Lichtquellen gezeigt sind, ist es möglich, eine aussagekräftige Ausleuchtung mit lediglich zwei, bevorzugt dimmbaren Lichtquellen zu erreichen, die an den beiden Enden eines Leuchtstabes einstrahlen.

Leuchtstäbe werden im Fahrzeugbau vermehrt eingesetzt, wobei Licht, z.B. von Leuchtdioden, an einer Stirnfläche in einen Leuchtstab eingespeist wird. Das Licht wird im Inneren an den Begrenzungswänden des meist kreisrunden, gegebenenfalls aber auch einen anderen, z.B. elliptischen oder rechteckigen Querschnitt aufweisenden Lichtleiters total reflektiert, jedoch an den Störstellen, die z.B. prismenartig ausgebildet sind, abgelenkt und im Wesentlichen an der den Störstellen gegenüberliegenden Seite abgestrahlt. Ein Beispiel für eine solche Lichtleiterstruktur ist aus der EP 0 935 091 A1 bekannt geworden. Gegenstand dieses Dokuments ist ein stabförmiger Lichtleiter, bei welchem zur Erzielung einer gleichmäßigen Leuchtdichte über die gesamte Länge als Störstellen vorgesehene lichtablenkende Prismen eine Breite quer zur Stabachse besitzen, die von der Lichteinkoppelfläche ausgehend zunimmt, wobei auch eine Ausführungsform beschrieben ist, bei welcher an beiden Enden des Lichtleiters eine Lichteinkoppelfläche und dementsprechend zwei Lichtquellen vorgesehen sind.

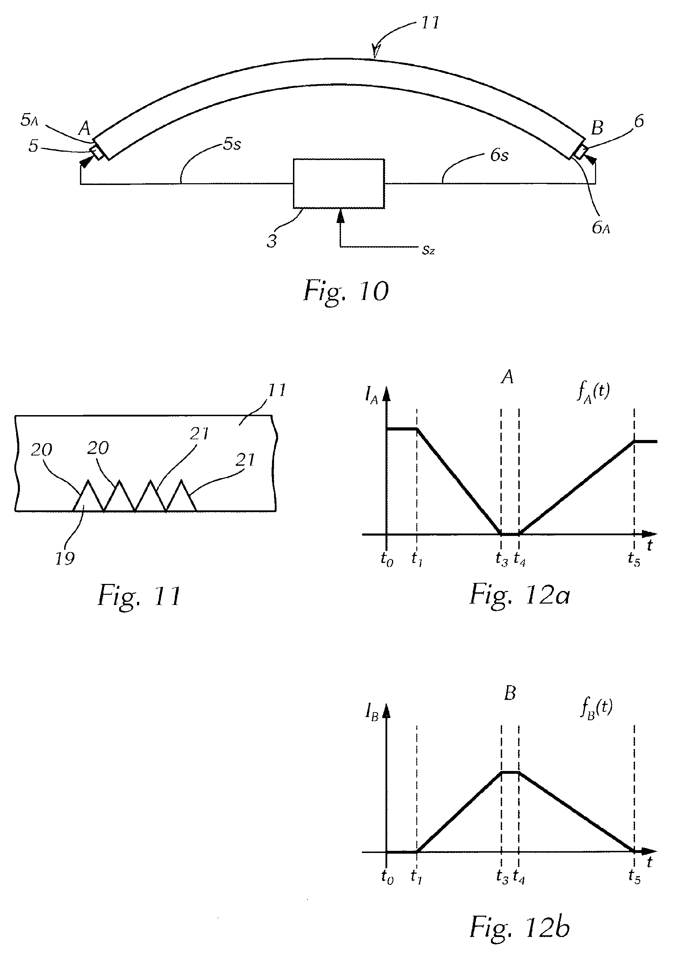

Die als Leuchtstab 11 ausgebildete Leuchtstruktur nach Fig. 10 zeigt einen leicht gekrümmten Lichtleiter, der an jedem seiner beiden Enden an einer Lichteinspeiseposition A bzw. B eine Lichtquelle 5 bzw. 6 aufweist, die Licht in eine Lichteintrittsfläche 5A, 6A einstrahlen kann. Jede der beiden Lichtquellen 5, 6 wird über Speiseleitungen 5s, 6s von der Ansteuerschaltung 3 angespeist, der das Zustandssignal sz zugeführt ist. Als Lichtquellen kommen bevorzugt LEDs in Frage, doch können auch andere Lichtquellen, wie Glühlampen, Xenonlampen etc. Anwendung finden.

Fig. 11 zeigt einen vergrößerten Abschnitt des Leuchtstabes 11, an dem eine Struktur aus Störstellen 19 ersichtlich ist. Dabei weisen die als Prismen ausgebildeten Störstellen je zwei Lichtflächenseiten auf, nämlich je Lichtflächenseiten 20 und Lichtflächenseiten 21. Dadurch wird ermöglicht, dass von beiden Seiten des Leuchtstabes 11eingespeistes Licht tatsächlich abgestrahlt wird, im Wesentlichen an der der Störstellenstruktur gegenüberliegenden Seite des Leuchtstabes.

Die im Rahmen der Erfindung verwendeten Lichtquellen müssen keineswegs weißes Licht abstrahlen oder monochromatisch sein, vielmehr können auch Lichtquellen mit veränderlichen Farben (RGB-Lichtquellen) verwendet werden. Dabei ist es möglich, beispielsweise einen Farbübergang von rot auf grün zu erzeugen.

Es wird nun auf die Fig. 12a und 12b Bezug genommen, welche in Diagrammen mögliche Zustände der durch die Steuerschaltung 3 vorgegebenen Intensitäts der Lichtquellen 5 und 6 an den Einspeisepositionen A und B zeigt, wobei man die gezeigten Verläufe auch als Dimmkurven bezeichnen kann.

Die Intensität 1A der ersten Lichtquelle 5 an der Position A geht beispielsweise von einem bestimmten Maximalwert aus, der beliebig definiert werden kann. Darauf folgt eine fallende Dimmrampe, wobei diese hier als Beispiel linear dargestellt ist, jedoch sind für sämtlich hier beschrieben Dimmrampen andere Kurvenformen möglich, deren Verlauf von der Zustandsänderung der Komponente abhängt. Hier sinkt die die Intensität der Lichtquelle an der Position A bis zu einem minimalen Wert ab um dann gemäß einer steigenden Dimmrampe hier linear anzusteigen. Am Ende der steigenden Dimmrampe hat dann die Lichtquelle 5 an der Position A wieder eine maximale Helligkeit erreicht.

Betrachtet man den Intensitätsverlauf der zweiten Lichtquelle 6 an der Position B, so sieht man, dass bei diesem Beispiel die zweite Lichtquelle so angesteuert wird, dass der Helligkeitsverlauf genau gegensätzlich zu jenem der ersten Lichtquelle 5 an der Position A ist. Diese Art der Ansteuerung macht mit verschiedenfarbigen Lichtquellen Sinn, da dadurch der Effekt entsteht, dass Licht von Position A (z.B. Grün) von dem Licht von Position B (z.B. Rot) wandert. Unter Annahme dieser Farben der beiden Lichtquellen leuchtet in einem ersten Zustandsbereich B1 der Leuchtstab in der Farbe Grün, d. h. einem Betrachter würde - im Beispiel einer Akkumulatorenbatterie - ein voller Ladezustand derselben angezeigt werden. In dem Zustandsbereich B2 würde andererseits der Leuchtstab in der Farbe Rot leuchten und einem Betrachter würde angezeigt werden, dass der Ladezustand gleich Null ist. Zwischen diesen Extrembereichen wird der Anteil der leuchtenden Fläche bzw. Länge durch das Verhältnis der Intensitäten der beiden Lichtquellen 5, 6 an den Stellen A, B angezeigt, entsprechend Zwischenstufen des Ladezustands einer Akkumulatorenbatterie in diesem Beispiel.

Wenn in den gezeigten Beispielen eine bestimmte Anzahl von Lichtquellen beschrieben und dargestellt ist, sollte es für den Fachmann klar sein, dass diese Zahlenangaben in keiner Weise einschränkend aufzufassen sind. Beispielsweise kann die Ausführung nach den Fig. 4 bis 8 eine größere Anzahl von Leuchtdioden als vier aufweisen. Auch muss die Leuchtstruktur keineswegs zwingend länglich ausgebildet sein, es kommen vielmehr auch Leuchtstrukturen mit anderer Geometrie, wie beispielsweise Ringe, Kreise mit beleuchteten Sektoren etc. in Frage.

## Patentansprüche

1. Statusanzeige für den Zustand einer betriebsrelevanten Komponente (1) eines Kraftfahrzeugs, bei welcher an einer von außen sichtbaren Position des Fahrzeugs eine von zumindest zwei Lichtquellen (5, 6; LED 1....LED 4) angespeiste Leuchtstruktur (4; 10; 11) angeordnet ist und den Lichtquellen eine Ansteuerschaltung (3) zugeordnet ist, welche dazu eingerichtet ist, die Lichtquellen in Abhängigkeit eines für den Zustand der betriebsrelevanten Komponente (1) repräsentativen Zustandssignals (sz) so anzusteuern, dass die Leuchtdichte und/oder Farbe längst der Leuchtstruktur skalenartig den Zustand der Komponente anzeigt,
**dadurch gekennzeichnet, dass**
die Leuchtstruktur zwei oder mehr der Leuchtstruktur zugeordnete Lichtquellen (5, 6; LED 1....LED 4) besitzt und zumindest einen Leuchtstab (11) mit zumindest zwei Lichteinspeise-positionen (A, B) besitzt, welchen je eine der zwei oder mehr Lichtquellen (5, 6) zugeordnet ist, wobei der Leuchtstab zur Führung des eingespeisten Lichts sowie zur Abstrahlung von Licht auf Grund von an dem Leuchtstab ausgebildeten Störstellen (19) eingerichtet ist, und die Ansteuerschaltung dazu eingerichtet ist, die Lichtquellen an den zumindest zwei Lichteinspeisepositionen dem Zustand der Komponente entsprechend anzusteuern.

2. Statusanzeige nach Anspruch 1, **dadurch gekennzeichnet, dass** die Lichtquellen als Leuchtdioden (LED 1....LED 4) ausgebildet sind.

3. Statusanzeige nach Anspruch 1 oder 2, **dadurch gekennzeichnet, dass** jede Lichtquelle zumindest eine Leuchtdiode (LED 1....LED 4) aufweist und jeder Lichtquelle eine Ansteuerschaltung (AS1 - AS4) zugeordnet ist, welche eine zur Leuchtdiode parallel geschaltete Serienschaltung einer Referenzspannungssenke (RS) der Spannung (Uref) und eines gesteuerten Schalters (Q) aufweist und die dazu eingerichtet ist, die Steuerspannung (Ust) an einer allen Ansteuerschaltungen gemeinsamen Steuerleitung (14), gemessen gegen einen Fußpunkt der LED-Serienschaltung, mit der Spannung an der Verbindung des Schalters mit der darauffolgenden LED der Kette bzw. dem Fußpunkt zu vergleichen und den Schalter zu schließen bzw. zu öffnen, falls die Steuerspannung (Ust) unter einen vorgegebenen Wert fällt bzw. über einen vorgegebenen Wert steigt.

4. Statusanzeige nach einem der Ansprüche 1 bis 3, **dadurch gekennzeichnet, dass** die Lichtquellen (5, 6; LED 1....LED 4) eine unterschiedliche Farbe abstrahlen.

5. Statusanzeige nach einem der Ansprüche 1 bis 4, **dadurch gekennzeichnet, dass** die Leuchtstruktur ((4; 10; 11) in/an einer Scheinwerfereinheit (7) des Kraftfahrzeuges angeordnet ist.

## Claims

1. A status display for the state of an operationally-relevant component (1) of a motor vehicle, wherein an illuminating structure (4; 10; 11) supplied by at least two light sources (5, 6; LED 1....LED 4) is arranged in a position of the vehicle which is visible from the outside and the light sources are associated with a control circuit (3), which is designed to control the light sources in accordance with a state signal (sz) representing the state of the operationally-relevant component (1), such that the luminance and/or colour along the illuminating structure indicates the state of the component in a scale-like manner,
**characterised in that**
the illuminating structure has two or more light sources (5, 6; LED 1....LED 4) associated with the illuminating structure and the illuminating structure has at least one light stick (11) having at least two light feed positions (A, B), which are each associated with the two or more light sources (5, 6), wherein the light stick is designed to guide the supplied light and to irradiate light on account of defects (19) formed on the light stick, and the control circuit is designed to control the light sources at the two light feed positions in accordance with the state of the component.

2. The status display according to Claim 1, **characterised in that** the light sources are formed as light-emitting diodes (LED 1....LED 4).

3. The status display according to Claim 1 or 2, **characterised in that** each light source has at least one light-emitting diode (LED 1....LED 4) and each light source is associated with a control circuit (AS1 - AS4), which has a series circuit of a reference voltage sink (RS) of the voltage (Uref) and of a controlled circuit (Q), which series circuit is connected in parallel with the light-emitting diode and is designed to compare the control voltage (Ust) measured across a control line (14) common to all controllers toward a base of the LED series circuit with the voltage across the connection of the switch to the subsequent LED in the chain or to the base and to close or open the switch if the control voltage (Ust) falls below a predefined value or rises above a predefined value respectively.

4. The status display according to one of Claims 1 to 3, **characterised in that** the light sources (5, 6; LED 1....LED 4) irradiate a different colour.

5. The status display according to one of Claims 1 to 4, **characterised in that** the illuminating structure (4; 10; 11) is arranged in/on a headlight unit (7) of the motor vehicle.

## Revendications

1. Affichage de statut pour l'état d'un composant fonctionnellement pertinent (1) d'un véhicule automobile, suivant lequel une structure éclairante (4 ; 10 ; 11) alimentée par au moins deux sources lumineuses (5, 6 ; LED1 ... LED4) est disposée dans une position du véhicule qui est visible de l'extérieur et aux sources lumineuses est associé un circuit de commande (3), lequel est conçu pour commander les sources lumineuses conformément à un signal d'état (sz) représentatif de l'état du composant fonctionnellement pertinent (1) de telle sorte que la luminance et/ou la couleur le long de la structure éclairante indique l'état du composant d'une manière de type échelle, **caractérisé par le fait que** la structure éclairante possède au moins deux sources lumineuses (5, 6 ; LED1 ... LED4) associées à la structure éclairante et possède au moins un bâton lumineux (11) ayant au moins deux positions d'alimentation lumineuse (A, B) à chacune desquelles est associée l'une des au moins deux sources lumineuses (5, 6), le bâton lumineux étant conçu pour guider la lumière alimentée ainsi que pour irradier de la lumière sur la base de défauts (19) formés sur le bâton lumineux, et le circuit de commande étant conçu pour commander les sources lumineuses aux les au moins deux positions d'alimentation lumineuse conformément à l'état du composant.

2. Affichage de statut selon la revendication 1, **caractérisé par le fait que** les sources lumineuses sont réalisées sous la forme de diodes électroluminescentes (LED1 ... LED4).

3. Affichage de statut selon l'une des revendications 1 ou 2, **caractérisé par le fait que** chaque source lumineuse présente au moins une diode électroluminescente (LED1 ... LED4) et qu'à chaque source lumineuse est associée un circuit de commande (AS1-AS4), qui présente un circuit série d'un puits de tension de référence (RS) de la tension (Uref) et d'un commutateur commandé (Q), lequel circuit série est connecté en parallèle avec la diode électroluminescente, et qui est conçu pour comparer la tension de commande (Ust) sur une ligne de commande (14) commune à tous les circuits de commande, mesurée vers une base du circuit série des LED, avec la tension sur la connexion du commutateur avec la LED suivante de la chaîne ou la base et pour fermer ou ouvrir le commutateur si la tension de commande (Ust) tombe au-dessous d'une valeur prédéfinie ou monte au-dessus d'une valeur prédéfinie.

4. Affichage de statut selon l'une des revendications 1 à 3, **caractérisé par le fait que** les sources lumineuses (5, 6 ; LED1 ... LED4) irradient une couleur différente.

5. Affichage de statut selon l'une des revendications 1 à 4, **caractérisé par le fait que** la structure éclairante (4 ; 10 ; 11) est disposée dans/sur une unité de phare (7) du véhicule automobile.
